# EUROPÄISCHE PATENTSCHRIFT

(11) **EP 3 736 579 B1**
(45) Veröffentlichungstag und Bekanntmachung des Hinweises auf die Patenterteilung: **10.09.2025**
(21) Anmeldenummer: 20160162.2
(22) Anmeldetag: 28.02.2020
(51) Int. Cl.: G01R 22/06, G01R 22/10

(54) **MULTI-MODALER METER**
MULTI-MODE METER
MÈTRE MULTIMODAL

(30) Priorität: 06.05.2019 DE 102019111682
(43) Veröffentlichungstag der Anmeldung: 11.11.2020
(73) Patentinhaber: Innogy SE, 45128 Essen (DE)
(72) Erfinder: Hammerschmidt, Torsten, 44267 Dortmund (DE); Radtke, Gerhard, 44869 Bochum (DE); Neumann, Olaf, 40878 Ratingen (DE)
(74) Vertreter: Cohausz & Florack

(56) Entgegenhaltungen:
- DE-A1- 102009 008 125
- US-A1- 2014 333 286
- US-A1- 2016 033 561
- US-B1- 9 618 548

## Beschreibung

### Gebiet der Erfindung

Die Erfindung betrifft einen elektronischen Zähler zur Erfassung von einer oder mehreren elektrischen Größen, z. B. in einem Haushalt.

### Hintergrund der Erfindung

Ein Beispiel für die Erfassung (z. B. Messung) von elektrischer Energie beim Haushaltskunden in der Niederspannung ist der Einbau eines Zählers für die bezogene elektrische Energie. Es haben sich dabei Wechselstromzähler, die eine Phase messen, und Drehstromzähler, die drei Phasen messen, etabliert. Neben elektromechanischen Zählern sind auch elektronische Zähler bekannt. Aufgrund der bei elektronischen Zählern vorhandenen Datenschnittstelle können diese beispielsweise mit Gateways und weiteren Steuer-, Auswerte- und/oder Kommunikationseinheiten (z. B. Server oder-Server-Cloud) verbunden werden.

Je nach Umfang der Zusatzgeräte- und -funktionalitäten (z. B. Messwertgeber, Steuergerät, ¼-Stunden-Messung, Fernauslesung, oder dergleichen) werden hierfür Begriffe wie Smartmeter, EDL21, EDL40, moderne Messeinrichtung, intelligenter Zähler/Haushaltszähler oder intelligentes Messsystem verwendet.

Als Basis verwenden alle diese vorgenannten Messsysteme einen elektronischen Zähler, durch den die zu messenden Ströme hindurchgeleitet werden, und die die gemessene hindurchgeflossene elektrische Energie in einer Anzeige direkt auf dem Zähler darstellen können. Neben einer geeichten und abrechnungsfähigen Energiemessung können im Display auch weitere Messgrößen ausgegeben werden, wie z. B. Strom, Spannung, Frequenz, Wirk-, Blind- und/oder Scheinleitung. Ebenso ist bei elektronischen Zählern die Ausgabe der Zählwerte in Sekunden- oder Minutenintervallen möglich.

Neben diesem Standardfall von einem Stromzähler pro Haushalt entstehen durch die Energiewende in immer mehr Haushalten Anwendungsfälle bzw. komplexe Messsituationen, die z. B. auch Einspeiseanlagen (z. B. PV-Anlagen) umfassen, die möglicherweise einen weiteren Zähler für die eingespeiste Energie benötigen. In einem Haushalt können beispielsweise unterschiedliche Erzeugungsanlagen zum Einsatz kommen, und/oder es sind ferner auch eine oder mehrere Batterien im Einsatz (zur Speicherung von elektrischer Energie). Dies kann den Einsatz von mehreren Zählern bzw. Zählwerken erforderlich machen, um beispielsweise gesetzeskonform alle notwendigen Erfassungen von Energiemengen durchführen zu können. Beispielsweise sind für einen multi-modalen Betrieb einer Batterie samt einer PV-Anlage in einem Haushalt derzeit fünf Zähler mit jeweils bis zu vier Zählwerken für die Energieabrechnung erforderlich. Jeder Zähler kann dabei ferner ein Display umfassen, das einen relativ großen Stromverbraucher im Zähler darstellt. All diese Komponenten werden mit Hilfsenergie versorgt. Ferner wird zu deren Betrieb ein aufwendig stabilisiertes und damit teures Netzteil benötigt, um Genauigkeitsklassen nach dem Eichrecht einhalten zu können.

Relevanter Stand der Technik wird unter anderem in US 2016/033561 A1 offenbart.

### Allgemeine Beschreibung einiger beispielhafter Ausgestaltungen der vorliegenden Erfindung

Es wäre wünschenswert, die vorgenannten Probleme aus dem Stand der Technik zu vermeiden bzw. zu verringern, und insbesondere für derartige komplexe Messsituationen eine einfache Lösung bereitstellen zu können, die z. B. den Installations-, Mess- und Geräteaufwand, und/oder den notwendigen Energieverbrauch reduziert.

Gemäß der Erfindung wird ein System nach dem unabhängigen Anspruch 1 definiert. Vorteilhafte Ausgestaltungen werden in den abhängigen Ansprüchen definiert.

Ein erfindungsgemäßes System umfasst eine Auswerte- und Kommunikationseinheit, welche im Folgenden auch als Vorrichtung gemäß einem ersten Aspekt benannt wird. Außerdem umfasst ein erfindungsgemäßes System auch ein oder mehrere Sensormodule, welche im Folgenden auch als Vorrichtung gemäß einem zweiten Aspekt benannt werden.

Gemäß einem ersten beispielhaften Aspekt des Gegenstands wird eine Vorrichtung vorgeschlagen, umfassend:
- mindestens eine Stromversorgungseinrichtung;
die dadurch gekennzeichnet ist, dass die Vorrichtung ferner umfasst:
- eine Einrichtung zum Auswerten und/oder Speichern von Informationen;
   wobei eine oder mehrere Informationen von einer oder mehreren mit der Vorrichtung verbindbaren Vorrichtungen zum Erfassen von Informationen (z. B. eine oder mehrere Vorrichtungen nach dem zweiten Aspekt) empfangbar sind, wobei die eine oder mehreren Informationen indikativ für eine oder mehrere elektrisch erfassbare Größen sind, die von einer jeweiligen der einen oder mehreren mit der Vorrichtung verbindbaren Vorrichtungen zum Erfassen von Informationen erfasst wurden,
   wobei die eine oder mehreren mit der Vorrichtung verbindbaren Vorrichtungen zum Erfassen von Informationen seitens der mindestens einen Stromversorgungseinrichtung mit elektrischer Energie versorgbar sind.

Die Vorrichtung nach dem ersten Aspekt ist beispielsweise eine (z. B. zentrale) Einheit, die mit einer oder mehreren Vorrichtungen nach dem zweiten Aspekt verbindbar ist. Die Vorrichtung nach dem ersten Aspekt ist beispielsweise eine Auswerte- und/oder Kommunikationseinheit, die die erfassten Informationen der einen oder mehreren Vorrichtungen nach dem zweiten Aspekt auswerten kann, und optional ferner mit weiteren Vorrichtungen, z. B. auch weitere Vorrichtungen neben der einen oder den mehreren Vorrichtungen nach dem zweiten Aspekt, kommunizieren kann.

Gemäß einem zweiten beispielhaften Aspekt des Gegenstands wird eine Vorrichtung zum Erfassen von Informationen vorgeschlagen, die Vorrichtung umfassend:
- eine oder mehrere Einrichtungen zum Erfassen von Informationen, wobei die eine oder mehreren Einrichtungen zum Erfassen von Informationen seitens mindestens einer Stromversorgungseinrichtung mit elektrischer Energie versorgbar sind; und wobei mittels der einen oder mehreren Einrichtungen zum Erfassen von Informationen Informationen erfassbar sind, wobei die erfassten Informationen indikativ für eine oder mehrere elektrisch erfassbare Größen sind, und wobei die erfassten Informationen sendbar sind.

Die Vorrichtung nach dem zweiten Aspekt umfasst beispielsweise eine oder mehrere Einrichtungen zum Erfassen von Informationen (z. B. ein oder mehrere Sensoren), z. B. zum Messen von einer oder mehreren elektrischen Größen (z. B. Strom und/oder Spannung, oder dergleichen). Die Vorrichtung nach dem zweiten Aspekt wird gegenständlich auch als Sensormodul bezeichnet.

Gemäß dem ersten und/oder zweiten Aspekt des Gegenstands wird auch eine alternative Vorrichtung beschrieben, umfassend zumindest einen Prozessor und zumindest einen Speicher mit Computerprogrammcode, wobei der zumindest eine Speicher und der Computerprogrammcode dazu eingerichtet sind, mit dem zumindest einen Prozessor zumindest die von der jeweiligen Vorrichtung nach dem ersten und/oder zweiten Aspekt umfassten Mittel auszuführen und/oder zu steuern. Unter einem Prozessor soll zum Beispiel eine Kontrolleinheit, ein Mikroprozessor, eine Mikrokontrolleinheit wie ein Mikrocontroller, ein digitaler Signalprozessor (DSP), eine anwendungsspezifische Integrierte Schaltung (ASIC) oder ein Field Programmable Gate Arrays (FPGA) verstanden werden.

Zum Beispiel umfasst eine beispielhafte Vorrichtung nach dem ersten und/oder zweiten Aspekt ferner Mittel zum Speichern von Informationen wie einen Programmspeicher und/oder einen Hauptspeicher. Zum Beispiel umfasst eine beispielhafte Vorrichtung nach dem ersten und/oder zweiten Aspekt ferner jeweils Mittel zum Empfangen und/oder Senden von Informationen über ein Netzwerk wie eine Netzwerkschnittstelle. Zum Beispiel sind beispielhafte Vorrichtungen nach dem ersten und/oder zweiten Aspekt über ein oder mehrere Netzwerke miteinander verbunden und/oder verbindbar.

Eine beispielhafte Vorrichtung gemäß dem ersten und/oder zweiten Aspekt ist oder umfasst etwa eine Datenverarbeitungsanlage, die softwaremäßig und/oder hardwaremäßig eingerichtet ist, um jeweilige Verfahrensschritte der von der jeweiligen Vorrichtung umfassten Mittel ausführen zu können, und/oder um die jeweiligen Mittel der jeweiligen Vorrichtung nach dem ersten und/oder zweiten Aspekt auszuführen und/oder zu steuern. Beispiele für eine Datenverarbeitungsanlage sind ein Computer, ein Desktop-Computer, ein Server, ein Thinclient und/oder ein tragbarer Computer (Mobilgerät), wie etwa ein Laptop-Computer, ein Tablet-Computer, ein Wearable, ein persönlicher digitaler Assistent oder ein Smartphone.

Weitere Vorrichtungen können vorgesehen sein, beispielswiese ein Server und/oder beispielsweise ein Teil bzw. eine Komponente einer sogenannten Computer Cloud, welche Datenverarbeitungsressourcen dynamisch für verschiedene Nutzer in einem Kommunikationssystem bereitstellt. Unter einer Computer Cloud wird insbesondere eine Datenverarbeitungs-Infrastruktur gemäß der Definition des "National Institute for Standards and Technology" (NIST) für den englischen Begriff "Cloud Computing" verstanden. Ein Beispiel einer Computer Cloud ist eine Microsoft Windows Azure Platform.

Gemäß dem ersten und/oder zweiten Aspekt des Gegenstands wird auch ein Computerprogramm beschrieben, das Programmanweisungen umfasst, die einen Prozessor zur Ausführung und/oder Steuerung jeweiligen Mittel der jeweiligen Vorrichtung nach dem ersten und/oder zweiten Aspekt veranlassen, wenn das Computerprogramm auf dem Prozessor läuft. Ein beispielhaftes Programm gemäß der Erfindung kann in oder auf einem computerlesbaren Speichermedium gespeichert sein, welches eines oder mehrere Programme enthält.

Gemäß dem ersten und/oder zweiten Aspekt der Erfindung wird auch ein computerlesbares Speichermedium beschrieben, welches ein Computerprogramm gemäß dem ersten und/oder zweiten Aspekt enthält. Ein computerlesbares Speichermedium kann z.B. als magnetisches, elektrisches, elektro-magnetisches, optisches und/oder andersartiges Speichermedium ausgebildet sein. Ein solches computerlesbares Speichermedium ist vorzugsweise gegenständlich (also "berührbar"), zum Beispiel ist es als Datenträgervorrichtung ausgebildet. Eine solche Datenträgervorrichtung ist beispielsweise tragbar oder in einer Vorrichtung fest installiert. Beispiele für eine solche Datenträgervorrichtung sind flüchtige oder nicht-flüchtige Speicher mit wahlfreiem-Zugriff (RAM) wie z.B. NOR-Flash-Speicher oder mit sequentiellen-Zugriff wie NAND-Flash-Speicher und/oder Speicher mit Nur-Lese-Zugriff (ROM) oder Schreib-Lese-Zugriff. Computerlesbar soll zum Beispiel so verstanden werden, dass das Speichermedium von einem Computer bzw. einer Datenverarbeitungsanlage (aus)gelesen und/oder beschrieben werden kann, beispielsweise von einem Prozessor.

Gemäß einem dritten beispielhaften Aspekt des Gegenstands wird ein System vorgeschlagen, wie es jetzt im unabhängigen Anspruch 1 definiert ist, umfassend:
- (z. B. genau) eine Vorrichtung nach dem ersten Aspekt des vorliegenden Gegenstands; und
- eine oder mehrere Vorrichtungen nach dem zweiten Aspekt des vorliegenden Gegenstands.

Die eine oder mehrere Vorrichtungen nach dem zweiten Aspekt sind beispielsweise mit der (z. B. genau) einen Vorrichtung nach dem ersten Aspekt (z. B. elektrisch) koppelbar bzw. verbindbar.

Diese drei Aspekte der vorliegenden Erfindung weisen u.a. die nachfolgend beschriebenen - teilweise beispielhaften - Eigenschaften auf.

Dabei liegt dem Gegenstand nach allen Aspekten die Erkenntnis zugrunde, dass eine komplexe Messsituation mit einer gegenständlichen Vorrichtung, die nach dem Baukastenprinzip aufgebaut ist, gelöst werden kann. Durch die technische Anpassung der gegenständlichen Vorrichtung an die jeweilige Messaufgabe kann auf redundante Komponenten (z. B. mehrfache Displays, Netzteile, um nur einige nicht-limitierende Beispiele zu nennen) bei Bedarf von mehreren Vorrichtungen nach dem zweiten Aspekt (z. B umfassend einen oder mehrere Sensoren und/oder Zähler) verzichtet werden. Der Gegenstand ermöglicht insbesondere die Probleme aus dem Stand der Technik zu vermeiden bzw. zu verringern, wenn beispielsweise an einer Messstelle (z. B. Messort, Messlokation, Hausanschluss, Netzverknüpfungspunkt, um nur einige nicht-limitierende Beispiele zu nennen) üblicherweise mehr als ein Zähler verwendet werden muss.

Die gegenständlichen Vorrichtungen nach allen Aspekten bzw. das gegenständliche System nach dem dritten Aspekt (im Nachfolgenden auch als Multi-Modaler Meter (M3) bezeichnet) ermöglicht die Trennung von z. B. einer oder mehreren Vorrichtungen nach dem zweiten Aspekt (z. B. Sensormodulen) und einer Vorrichtung nach dem ersten Aspekt (z. B. eine Auswerte- und/oder Kommunikationseinheit), wobei erste und letztere beispielsweise in jeweils getrennten Gehäusen angeordnet sind. D.h. die Sensormodule bilden beispielsweise als abgesetzte Erfassungsmodule zusammen mit der Auswerte- und/oder Kommunikationseinheit ein geeichtes Messsystem, das beispielsweise allen gesetzlichen Anforderungen (z. B. an abrechnungsrelevante Energiezähler) entspricht bzw. genügt (z. B. dem Messstellenbetriebsgesetz im Falle von Deutschland). Damit werden je Messstelle zwar mehrere Sensormodule, aber nur eine Auswerte- und/oder Kommunikationseinheit benötigt. Ein Sensormodul umfasst beispielsweise einen oder mehrere Sensoren, die in diesem Konzept beispielsweise eichrechtskonform Spannung und/oder Strom messen. Anschließend werden diese (gemessenen) Werte als digital gewandelte Werte von dem jeweiligen Sensormodul an die (z. B. zentrale) Auswerte- und/oder Kommunikationseinheit ausgegeben. Das Sensormodul umfasst beispielsweise einen einphasigen Sensor und/oder einen Wechselstromsensor. Bei drei Sensormodulen z. B. für die drei Phasen eines Drehstromsystems wird beispielsweise die Funktionalität eines Drehstromzählers erreicht, um nur ein nicht-limitierendes Beispiel zu nennen.

Das System gemäß dem dritten Aspekt umfasst oder besteht beispielsweise aus einem oder mehreren Sensormodulen (jeweils Vorrichtungen nach dem zweiten Aspekt) und einer Auswerte- und/oder Kommunikationseinheit (eine Vorrichtung nach dem ersten Aspekt). Ein derartiges System erlaubt es beispielsweise, eine eichrechtskonforme Erfassung von Energiemengen auszuführen und/oder zu steuern. Es wird z. B. mindestens eine Vorrichtung nach dem zweiten Aspekt (z. B. vorgenanntes Sensormodul) zur Abrechnung einer Energiemenge benötigt, es können aber auch mehrere Vorrichtungen nach dem zweiten Aspekt zur Abrechnung einer Energiemenge dienen (z. B. drei Sensormodule, die zusammen eine Drehstromerfassung ermöglichen), sowie mehrere Vorrichtungen nach dem zweiten Aspekt zur Abrechnung mehrerer Energiemengen dienen (z. B. bei unterschiedlichen Abrechnungsempfängern).

Die Vorrichtung nach dem ersten Aspekt umfasst mindestens eine Stromversorgungseinrichtung. Eine derartige Stromversorgungseinrichtung ist beispielsweise ein Netzteil. Eine derartige Stromversorgungseinrichtung ist beispielsweise ein stabilisiertes Netzteil. Hierrunter wird gegenständlich insbesondere ein Netzteil verstanden, dass eine konstante Ausgangsspannung sicherstellt. Alternativ oder zusätzlich ist eine derartige Stromversorgungseinrichtung beispielsweise (z. B. hoch) geschützt. Hierrunter wird gegenständlich insbesondere verstanden, dass diese z. B. im Fehlerstrom Fall nicht beschädigt wird.

Die Vorrichtung nach dem ersten Aspekt umfasst (z. B. mindestens) eine Einrichtung zum Auswerten und/oder Speichern von Informationen. Hierbei handelt es sich beispielsweise um einen Speicher. Alternativ oder zusätzlich umfasst die Einrichtung zum Auswerten und/oder Speichern von Informationen beispielsweise einen Prozessor (z. B. CPU). Gespeicherte Informationen können dann z. B. seitens des Prozessors ausgewertet (z. B. (weiter-) verarbeitet) werden.

Die eine oder mehrere Informationen sind von einer oder mehreren mit der Vorrichtung verbindbaren Vorrichtungen zum Erfassen von Informationen (z. B. Vorrichtungen nach dem zweiten Aspekt) empfangbar. Hierzu senden die eine oder mehreren Vorrichtungen zum Erfassen von Informationen beispielsweise die Informationen, z. B. direkt an die Vorrichtung nach dem ersten Aspekt, oder an eine weitere Vorrichtung (z. B. ein Gateway, Server, oder eine Server-Cloud, um nur einige nicht-limitierende Beispiele zu nennen). Dann stehen diese Informationen beispielsweise der Einrichtung zum Auswerten und/oder Speichern von den Informationen z. B. zur weiteren Nutzung zur Verfügung. Beispielsweise kann eine derartige weitere Vorrichtung (z. B. ein Gateway, Server, oder eine Server-Cloud) zwischen einer Vorrichtung nach dem ersten Aspekt und einer oder mehreren Vorrichtungen nach dem zweiten Aspekt (kommunikationstechnisch) angeordnet sein. Informationen zwischen der Vorrichtung nach dem ersten Aspekt und einer oder mehreren Vorrichtungen nach dem zweiten Aspekt erfolgen dann beispielsweise über eine derartige weitere Vorrichtung. Eine derartige weitere Vorrichtung kann beispielsweise von einem System nach dem dritten Aspekt umfasst sein.

Die eine oder mehreren Informationen sind indikativ für eine oder mehrere elektrisch erfassbare Größen, die von einer jeweiligen der einen oder mehreren mit der Vorrichtung verbindbaren Vorrichtungen zum Erfassen von Informationen erfasst wurden. Derartige elektrisch erfassbare Größen sind beispielsweise Spannungs- und/oder Strommesswerte, die beispielsweise über einen vordefinierten Zeitraum, und/oder in regelmäßigen Intervallen und/oder Abständen (z. B. im 1, 2, 5, 10, oder mehr Sekundentakt, und/oder alle 1, 2, 3, 4, 5, 10, 15, 30, 60 Minuten oder mehr, um nur einige nicht-limitierende Beispiele zu nennen) erfassbar sind.

Die eine oder mehreren mit der Vorrichtung nach dem ersten Aspekt verbindbaren Vorrichtungen (nach dem zweiten Aspekt) sind zum Erfassen von Informationen seitens der mindestens einen Stromversorgungseinrichtung mit elektrischer Energie versorgbar. Hierzu besteht eine Verbindung zur Stromversorgung zwischen den Entitäten oder es ist eine entsprechende Verbindung herstellbar bzw. etablierbar.

Für den Fall, dass Informationen von mehreren Vorrichtungen zum Erfassen von Informationen seitens der Vorrichtung nach dem ersten Aspekt empfangen werden, sind beispielsweise alle Informationen (z. B. die (Mess-) Werte von allen Sensoren umfasst von den Vorrichtungen zum Erfassen von Informationen nach dem zweiten Aspekt) speicherbar. Anschließend sind diese gespeicherten Informationen beispielsweise in dieser einzigen Vorrichtung nach dem ersten Aspekt (z. B. eine Auswerte- und/oder Kommunikationseinheit) weiterverarbeitbar.

Beispielsweise umfasst oder enthält die Vorrichtung nach dem ersten Aspekt (z. B. eine Auswerte-/Kommunikationseinheit), oder die Einrichtung zum Auswerten und/oder Speichern von Informationen verschiedene Register, in die die Informationen (z. B. Energiemengen in Einspeise- bzw. Verbrauchsrichtung eichrechtskonform gezählt) speicherbar sind. Es sind beispielsweise mehrere eichrechtskonforme Register in Einspeise- und/oder Verbrauchsrichtung in der Vorrichtung nach dem ersten Aspekt (z. B. eine Auswerte-/Kommunikationseinheit), oder in der Einrichtung zum Auswerten und/oder Speichern von Informationen enthalten oder umfasst.

Eine bzw. mehrere elektrische Größen im Sinne des Gegenstands umfassen oder repräsentieren beispielsweise einen Messwert eines Stroms, einer Spannung, einer Frequenz, einer Wirk-, Blind- und/oder Scheinleitung, oder einer Kombination hiervon, um nur einige nicht-limitierende Beispiele zu nennen.

Die Vorrichtung umfasst beispielsweise ferner eine Anzeigeeinrichtung (z. B. ein Display) zur Wiedergabe und/oder Eingabe (z. B. per Touchscreen) von Informationen. In diesem Fall wird im Unterschied zu bekannten Lösungen nur eine (einzige) Anzeigeeinrichtung benötigt. Die Anzeigeeinrichtung ist dann beispielsweise von der Vorrichtung nach dem ersten Aspekt des Gegenstands umfasst. Einrichtungen zum Erfassen von Informationen (z. B. Sensoren, die eine oder mehrere elektrische Größen messen können), umfasst von der Vorrichtung nach dem zweiten Aspekt, müssen in diesem Fall keine eigene Anzeigeeinrichtung umfassen oder aufweisen, da diese mit der Vorrichtung nach dem ersten Aspekt verbindbar sind, so dass beispielsweise nach der Übertragung von Informationen (z. B. Messwerte) diese einem Benutzer seitens der von der Vorrichtung nach dem ersten Aspekt optional umfassten Anzeigeeinrichtung wiedergegeben werden können.

Ferner können beispielsweise alle erfassten (z. B. gemessenen) Informationen (z. B. Messwerte) an einem Display angezeigt werden. Damit sind diese beispielsweise übersichtlich für einen oder mehrere Benutzer an einem Ort (z. B. dem Aufstellungsort der Vorrichtung nach dem ersten Aspekt) verfügbar. Gegebenenfalls muss ein Benutzer sich zur Anzeige von erfassten und seitens der Vorrichtung nach dem ersten Aspekt empfangenen Informationen legitimieren. Damit werden diesem Benutzer beispielsweise nur im Berechtigungsfall (z. B. in einem Mehrfamilienhaus) Informationen angezeigt, die beispielsweise ausschließlich den Verbrauch von elektrischer Energie des Benutzers betreffen. Dies kann in einer Ausgestaltung nach allen Aspekten beispielsweise durch die Eingabe einer PIN erfolgen, die ein Benutzer beispielsweise über ein Eingabegerät (z. B. berührungsempfindliches Display als Anzeigeeinrichtung, um nur ein nicht-limitierendes Beispiel zu nennen) eingeben kann.

Ferner wird beispielsweise nur eine Stromversorgungseinrichtung (z. B. ein hochwertiges Netzteil) für die Versorgung aller Komponenten der Vorrichtung nach dem ersten Aspekt und der Vorrichtung nach dem zweiten Aspekt, die gemeinsam die Funktionalitäten eines bisher bekannten (z. B. digitalen) (Strom-) Zählers realisieren, benötigt.

Die minimale Anzahl von Mitteln (z. B. technische Komponenten der Vorrichtung nach dem ersten Aspekt im Zusammenspiel mit einer oder mehreren Vorrichtungen nach dem zweiten Aspekt) z. B. im Vergleich zur Messung mit zwei Standard-Zählern bei einem Photovoltaik (PV)-Haushaltskunden (mit Eigenverbrauchsnutzung) ist beispielsweise um zwei Einrichtungen zur Erfassung von Informationen (z. B. Sensoren) geringer, wobei beispielsweise die Einrichtungen zur Erfassung von Informationen (z. B. Sensoren) entweder von einer einzigen Vorrichtung nach dem zweiten Aspekt (z. B. ein Sensormodul) umfasst sind, oder alternativ ist jeweils eine Einrichtung zur Erfassung von Informationen (z. B. Sensor) von einer dedizierten Vorrichtung nach dem zweiten Aspekt (z. B. ein Sensormodul) umfasst. Es können beispielsweise eine Vorrichtung nach dem ersten Aspekt (z. B. Auswerte- und/oder Kommunikationseinheit) und gegebenenfalls bis zu zwei Vorrichtungen nach dem zweiten Aspekt (zum Messen) entfallen. Wird zudem im Haushalt neben der PV-Anlage ein multi-modal genutzter Batteriespeicher betrieben, sind im Gegensatz zu fünf Zählern, die bei bekannten Lösungen erforderlich wären, gegenständlich nur maximal fünf Vorrichtungen nach dem zweiten Aspekt (umfassend jeweils drei Einrichtungen zur Erfassung von Informationen; z. B. drei Phasenwechselspannungssensoren) und eine Vorrichtung nach dem ersten Aspekt (z. B. Auswerte-/Kommunikationseinheit) erforderlich.

Die Vorrichtung nach dem ersten und/oder zweiten Aspekt benötigt beispielsweise weniger Hilfsstromverbrauch bei Betrachtung des Gesamtsystems (z. B. der gesamten Messstelle; System nach dem dritten Aspekt) z. B. durch eine geringere Anzahl notwendiger technischer Komponenten. Da z. B. nur die Vorrichtung nach dem ersten Aspekt eine Anzeigeeinrichtung aufweist, und diese Vorrichtung nach dem ersten Aspekt dann mit einer Vielzahl (z. B. mindestens zwei) Vorrichtungen nach dem zweiten Aspekt verbindbar ist, benötigt diese Vielzahl von Vorrichtungen nach dem zweiten Aspekt beispielsweise jeweils keine eigene Anzeigeeinrichtung, um nur ein nicht-limitierendes Beispiel zu nennen.

Beispielsweise kann die notwendige Hilfsenergie zum Betrieb der von der Vorrichtung nach dem ersten und/oder zweiten Aspekt umfassten technischen Komponenten (z. B. die gesamten komplexe Messstelle) netzseitig entnommen werden. Dies ist z. B. bei einer komplexen Messstelle mit einem multi-modal betriebenen Batteriespeicher mit fünf Zählern derzeit nicht möglich, um nur ein nicht-limitierendes Beispiel zu nennen.

Die Auftrennung des Gesamtsystems (z. B. ein System nach dem dritten Aspekt) zwischen einer Vorrichtung nach dem ersten Aspekt und einer oder mehreren Vorrichtungen nach dem zweiten Aspekt erlaubt es beispielsweise ferner, Primärströme auf zu messenden Phasen (z. B. im Anwendungsfall eines Stromzählers) nicht mehr durch ein Gehäuse der Vorrichtung nach dem ersten Aspekt (z. B. Auswerte-/Kommunikationseinheit) leiten zu müssen. Daraus ergeben sich eine vereinfachte Montage und Vorteile bei der notwendigen elektromagnetischen Abschirmung, die in ihrer Komplexität deutlich reduzierbar ist.

Gemäß der Erfindung sind die Vorrichtung nach dem ersten Aspekt und die einen oder mehreren Vorrichtungen zum Erfassen von Informationen nach dem zweiten Aspekt (voneinander) separiert.

Dies ermöglicht es beispielsweise, dass z. B. Primärströme auf zu messenden Phasen nicht mehr durch die Vorrichtung nach dem ersten Aspekt des Gegenstands (z. B. das Gehäuse der Auswerte-/Kommunikationseinheit) geleitet werden müssen. Elemente bzw. technische Komponenten der Vorrichtung nach dem ersten Aspekt des Gegenstands (wie z. B. die Einrichtung zum Auswerten und/oder Speichern von Informationen) müssen daher beispielsweise gegenüber elektrischen Feldern nicht mehr so stark wie bei aus dem Stand der Technik bekannten Lösungen abgeschirmt werden. Ferner können beispielsweise redundante Komponenten weitestgehend vermieden werden.

In einer Ausgestaltung nach dem ersten Aspekt des Gegenstands ist die mindestens eine Stromversorgungseinrichtung mit der einen oder den mehreren Vorrichtungen zum Erfassen von Informationen elektrisch verbunden, so dass elektrische Energie von der mindestens einen Stromversorgungseinrichtung an die eine oder mehreren Vorrichtungen zum Erfassen von Informationen übertragbar ist.

Somit ist beispielsweise seitens der mindestens einen Stromversorgungseinrichtung (umfasst von der Vorrichtung nach dem ersten Aspekt) eine Energieversorgung von einer oder mehreren Vorrichtungen nach dem zweiten Aspekt ermöglicht. Die Energieversorgung der einen oder mehreren Vorrichtungen nach dem zweiten Aspekt ist beispielsweise derart ermöglicht, dass eine Stromleitung (z. B. in Form eines Kabels) von einem entsprechenden Anschluss der Vorrichtung nach dem ersten Aspekt zu einem korrespondierenden Anschluss der einen oder mehreren Vorrichtungen nach dem zweiten Aspekt führt.

Die mindestens eine Stromversorgungseinrichtung ist beispielsweise von einem Dreiphasen-Anschluss, z. B. ein Hausanschluss in einem Haushalt, gespeist. Abgehend von der mindestens einen Stromversorgungseinrichtung wird mittels eines derartigen Anschlusses beispielsweise die notwendige Betriebsspannung für die eine oder mehreren Vorrichtungen nach dem zweiten Aspekt bereitgestellt. Hierfür kann die mindestens eine Stromversorgungseinrichtung beispielsweise entsprechende Wandler (z. B. AC/DC- und/oder DC/AC- und/oder AC/AC und/oder DC/DC-Wandler) umfassen.

In einer Ausgestaltung nach dem ersten Aspekt des Gegenstands umfasst die Vorrichtung ferner:
- mindestens eine Kommunikationsschnittstelle, wobei die eine oder mehrere Informationen, die empfangen (z. B. und/oder gespeichert wurden seitens der Einrichtung zum Auswerten und/oder Speichern von Informationen) wurden, über die mindestens eine Kommunikationsschnittstelle ferner ausgebbar sind (z. B. an einen Server oder eine Server-Cloud oder ein Gateway).

Beispielsweise ist die Kommunikationsschnittstelle für eine drahtgebundene oder drahtlose Kommunikation eingerichtet. Beispielsweise ist die Kommunikationsschnittstelle eine Netzwerkschnittstelle. Die Kommunikationsschnittstelle ist bevorzugt dazu eingerichtet mit einem Kommunikationssystem zu kommunizieren. Beispiele für ein Kommunikationssystem sind ein lokales Netzwerk (LAN), ein großräumiges Netzwerk (WAN), ein drahtloses Netzwerk (beispielsweise gemäß dem IEEE-802.11-Standard, dem Bluetooth (LE)-Standard und/oder dem NFC-Standard), ein drahtgebundenes Netzwerk, ein Mobilfunknetzwerk, ein Telefonnetzwerk und/oder das Internet. Ein Kommunikationssystem kann die Kommunikation mit einem externen Computer umfassen, beispielsweise über eine Internetverbindung.

Empfangene (und optional seitens der Einrichtung zum Auswerten und/oder Speichern von Informationen gespeicherte) Informationen sind beispielsweise über bzw. mittels der Kommunikationsschnittstelle an weitere Entitäten (z. B. ein Gateway, Server oder eine Server-Cloud, um nur einige nicht-limitierende Beispiele zu nennen) ausgebbar.

Derart können alle erfassten (z. B. gemessenen) Informationen (z. B. Messwerte) der einen oder mehreren Vorrichtungen nach dem zweiten Aspekt nach deren Empfang durch die Vorrichtung nach dem ersten Aspekt über die mindestens eine Kommunikationsschnittstelle der Vorrichtung nach dem ersten Aspekt ausgegeben werden. Lediglich die Vorrichtung nach dem ersten Aspekt (z. B. eine einzige Auswerte- und/oder Kommunikationseinheit) ist hierfür z. B. an eine weitere Vorrichtung, wie z. B. ein Gateway (z. B. zur Weiterverarbeitung der Messwerte) angeschlossen bzw. stellt eine Kommunikationsverbindung zu der weiteren Vorrichtung her. Dies bedeutet beispielsweise einen geringeren Installationsaufwand.

Ein derartiges Gateway kann beispielsweise ferner von dem System nach dem dritten Aspekt umfasst sein. Ferner kann ein derartiges Gateway beispielsweise seitens der Vorrichtung nach dem ersten Aspekt umfasst sein, z. B. in dem das Gateway in die Vorrichtung nach dem ersten Aspekt (z. B. eine Auswerte-/Kommunikationseinheit) integriert ist. Ein Gateway bietet beispielsweise weitere Kommunikations- und/oder Steuerungsmöglichkeiten, sowie optional weiteren Speicherplatz für Informationen (z. B. Messwerte (z. B. Strom, Spannung, Frequenz, etc.)), die beispielsweise seitens der einen oder mehreren Vorrichtungen nach dem zweiten Aspekt erfasst wurden.

In einem beispielhaften Anwendungsfall können z. B. über die Kommunikationsschnittstelle die gemessenen (Mess-) Werte Kunden bzw. Benutzern auch für andere Anwendungen/Geräte zur Verfügung gestellt werden. In einer weiteren Ausgestaltung nach allen Aspekten können dies z. B. Displays in Wohnungen der Kunden sein, um nur ein nicht-limitierendes Beispiel zu nennen. Im Fall eines Systems gemäß dem dritten Aspekt in einem Mehrfamilienhaus können mögliche Anwendungen ebenfalls, z. B. über eine Legitimierungs-PIN, die ein Kunde bzw. Benutzer zu seiner Legitimierung eingeben muss, anschließend dem Kunden zugehörigen (Mess-) Werte repräsentiert von empfangenen Informationen der Vorrichtung nach dem ersten Aspekt dargestellt werden.

Eine Datenkommunikation zwischen der einen oder den mehreren Vorrichtungen nach dem zweiten Aspekt und der Vorrichtung nach dem ersten Aspekt erfolgt beispielsweise per Funk und/oder über optische Schnittstellen, um nur einige nicht-limitierende Beispiele zu nennen.

In einer Ausgestaltung nach dem ersten Aspekt des Gegenstands sind die eine oder mehrere Informationen, die empfangen wurde, verschlüsselt über die Kommunikationsschnittstelle ausgebbar.

Die Kommunikationsschnittstelle kann beispielsweise eine verschlüsselte Kommunikation ermöglichen. Beispielsweise können Informationen (z. B. Messwerte in Form von Daten oder Datenpaketen) über eine Datenleitung zusätzlich oder alternativ verschlüsselt übermittelt werden. Hierfür eigenen sich regelmäßige Verschlüsselungsverfahren nach definierten Standards, wie etwa Ende-zu-Ende, Transport Layer Security (TLS), Secure Sockets Layer (SSL) Verschlüsselungen, um nur einige nicht-limitierende Beispiele zu nennen.

In einer Ausgestaltung nach dem ersten Aspekt des Gegenstands besteht jeweils eine Datenverbindung von der Vorrichtung (nach dem ersten Aspekt) zu der einen oder den mehreren Vorrichtungen zum Erfassen von Informationen (nach dem zweiten Aspekt) oder eine entsprechende Verbindung ist herstellbar.

In einer Ausgestaltung nach dem ersten und/oder zweiten Aspekt des Gegenstands umfasst die Vorrichtung ferner:
- mindestens einen Anschluss für eine Stromleitung; und
- mindestens einen Anschluss für eine Datenleitung;
   wobei der mindestens eine Anschluss für die Stromleitung und/oder der mindestens eine Anschluss für die Datenleitung mit korrespondierenden Anschlüssen der einen oder der mehreren Vorrichtungen zum Erfassen von Informationen jeweils verbindbar sind.

Derartige Anschlüsse umfasst von den jeweiligen Vorrichtungen nach dem ersten und/oder zweiten Aspekt stellen beispielsweise Verbindungsmöglichkeiten (z. B. nach der Art von Stecker und Buchse) bereit, um (z. B. elektrische) Strom- und/oder Datenleitung an den jeweiligen Vorrichtungen nach dem ersten und/oder zweiten Aspekt anzuschließen.

In einzelnen Ausgestaltungen nach allen Aspekten des Gegenstands sind zusätzlich folgende Merkmale möglich, die jeweils einzeln oder miteinander kombiniert realisiert sein können:
- Die Strom- und/oder Datenleitung zwischen Sensormodul und Auswerte- und/oder Kommunikationseinheit sind z. B.:
- als getrennte Leitungen ausgeführt;
- in einer gemeinsam ummantelten Leitung ausgeführt;
- mit einem elektrische geschirmten Mantel ausgeführt;
- beiderseits steckfertig ausgeführt;
- beiderseits in einem Gehäusebereich gesteckt, der nur durch Öffnung der Plombierung zugänglich ist;
- seriell und nicht als jeweils separate Verbindungen; d.h. es braucht nur eines der Sensormodule (Vorrichtung nach dem zweiten Aspekt) mit der Auswerte- und/oder Kommunikationseinheit (Vorrichtung nach dem ersten Aspekt) verbunden werden (nach Art eines Bussystems);
- bei einer Huckepack-Installation von Sensormodulen durch direkte Steckverbindung auf dem jeweils darunter liegenden Sensormodul ausgeführt; und/oder
- von der Auswerte- und/oder Kommunikationseinheit und/oder dem Sensormodul in ihrer einwandfreien Funktion überwacht, um Manipulationen weiter zu erschweren;
- von der Auswerte- und/oder Kommunikationseinheit und/oder dem Sensormodul mit einer verschlüsselten Kommunikation versehen.

Gemäß der Erfindung ist in der Einrichtung zum Auswerten und/oder Speichern von Informationen ferner eine Pairing-Information speicherbar, wobei die Pairing-Information eine Assoziierung der Vorrichtung zu einer definierten Vorrichtung der einen oder mehreren Vorrichtungen repräsentiert, so dass keine Informationen von (z. B. seitens der Vorrichtung nach dem ersten Aspekt) Vorrichtungen nach dem zweiten Aspekt empfangbar sind, die nicht gemäß der entsprechenden Pairing-Information definiert sind.

Bei der Installation eines Systems nach dem dritten Aspekt ist beispielsweise ein Pairing zwischen der einen oder den mehreren Vorrichtungen nach dem zweiten Aspekt (z. B. ein oder mehrere Sensormodule) und der Vorrichtung nach dem ersten Aspekt möglich. Ferner ist beispielsweise ein Pairing zwischen der einen oder den mehreren Vorrichtungen nach dem zweiten Aspekt (z. B. ein oder mehrere Sensormodule) und einer definierten Messaufgabe (z. B. indikativ für eine bestimmte elektrische Größe in Verbindung mit einer zu überwachenden bzw. zu messenden Komponente (z. B. eine Erzeugungseinrichtung, wie etwa eine PV-Anlage, ein Energiespeicher, oder (z. B. unmittelbar) erfolgenden Verbrauch, um nur einige nicht-limitierende Beispiele zu nennen)) möglich.

In einer Ausgestaltung können z. B. Identifikationsinformationen (z. B. IDs, und/oder ID-Nummern, und/oder Seriennummern) der einen oder mehreren Vorrichtungen nach dem zweiten Aspekt von der Vorrichtung nach dem ersten Aspekt ausgelesen werden. Diese können ferner in einer Anzeigeeinrichtung der Vorrichtung nach dem ersten Aspekt wiedergegeben werden. Durch z. B. Eingabemittel (z. B. Bedientasten) umfasst von der Vorrichtung nach dem ersten Aspekt können beispielsweise die Identifikationsinformationen der einen oder mehreren Vorrichtungen nach dem zweiten Aspekt dann bestimmten z. B. sogenannten OBIS (Object Identification System)-Kennzahlen und/oder Kunden zugeordnet werden. Für diese Bereiche können ferner beispielsweise initiale PINs vergeben werden. Damit eine spätere Umparametrierung der Vorrichtung(en) nach dem ersten und/oder zweiten Aspekt z. B. nur durch Berechtige (z. B. Fachpersonal) erfolgen kann, kann in einer weiteren Ausgestaltung beispielsweise ein Eingabemittel (z. B. ein Taster) im Bereich eines Gehäuses der Vorrichtung nach dem ersten Aspekt vorgesehen sein, der beispielsweise nur bei gelöster Plombierung zugänglich ist (z. B. auf einer Gehäuseunterseite). Nach dem Drücken eines derartigen Tasters ist die Parametrierung und Zuordnung der Vorrichtung(en) nach dem zweiten Aspekt dann beispielsweise für eine bestimmte Zeitdauer (z. B. 1, 2, 4, 5, 10, 15, 20, 30, oder mehr Minuten) möglich. Nach dem Ablauf der bestimmten Zeitdauer ist dann diese Umparametrierung zunächst nicht mehr möglich, z. B. bis zum erneuten Drücken des Tasters gesperrt.

Es versteht sich, dass die Einrichtung zum Auswerten und/oder Speichern von Informationen mehrere solcher Pairing-Informationen speichern kann.

In einer Ausgestaltung nach dem ersten Aspekt des Gegenstands ist die Einrichtung zum Auswerten und/oder Speichern von Informationen konfiguriert, empfangene eine oder mehrere Informationen weiter zu verarbeiten (z. B. mittels eines Prozessor und mindestens eines Speichers, die beispielsweise von der Vorrichtung nach dem ersten Aspekt des Gegenstands umfasst sind).

Ein derartiger Prozessor kann beispielsweise Informationen vor der Ausgabe über die Kommunikationsschnittstelle verschlüsseln, um nur ein nicht-limitierendes Beispiel zu nennen.

Mittels der einen oder mehreren Einrichtungen zum Erfassen von Informationen, die von der Vorrichtung nach dem zweiten Aspekt umfasst sind, sind Informationen erfassbar (z. B. messbar). Die erfassten Informationen sind indikativ für eine oder mehrere elektrisch erfassbare Größen. Die erfassten Informationen sind sendbar z. B. an eine Vorrichtung nach dem ersten Aspekt.

Die eine oder mehrere Einrichtungen zum Erfassen von Informationen sind jeweils beispielsweise als Sensor ausgebildet, oder umfassen zumindest einen Sensor, so dass zumindest eine Information indikativ für eine elektrische erfassbare Größe (z. B. Strom, Spannung, oder dergleichen) erfassbar (z. B. messbar) ist.

Ein derartiger Sensor misst in diesem Konzept beispielsweise eichrechtskonform (z. B. nur) Spannung und/oder Strom.

Ein derartiger Sensor ermöglicht beispielsweise das Erfassen einer Wirkenergie, die beispielsweise als Lastgang mit einem Wert je ¼-Stunde erfasst werden kann. Andere Zeitintervalle (z. B. 1s, 5s, 10s, 15s, 20s, 30s, 1min, 2min, 3 min, 4 min, 5min, 10min, oder mehr, um nur einige nicht-limitierende Beispiele zu nennen) sind ebenfalls möglich und/oder einstellbar.

Ein derartiger Sensor erfasst eine oder mehrere elektrische Größen beispielsweise in analoger Form. Vor deren Ausgabe (z. B. Senden) an eine Vorrichtung nach dem ersten Aspekt sind diese erfassten Informationen beispielsweise in digitale Informationen konvertier bar. Nach dem Senden (mittels der Vorrichtung nach dem zweiten Aspekt) und damit verbundenen Empfang (seitens der Vorrichtung nach dem ersten Aspekt) kann beispielsweise eine Vorrichtung nach dem ersten Aspekt diese empfangenen Informationen in einem integrierten Datenspeicher eichrechtskonform ablegen.

Neben einer derartigen eichrechtskonformen Erfassung (z. B. Messung) z. B. der Wirkenergie kann auch Blindenergie eichrechtskonfrom erfasst werden. In beiden Fällen wird das Vorzeichen der Energieflüsse erfasst und erlaubt in jedem Quadranten die Abrechnung;

In einer Ausgestaltung nach dem zweiten Aspekt des Gegenstands umfasst die Vorrichtung ferner:
- mindestens einen Anschluss für eine Stromleitung; und
- mindestens einen Anschluss für eine Datenleitung;
   wobei der mindestens eine Anschluss für die Stromleitung und/oder der mindestens eine Anschluss für die Datenleitung mit korrespondierenden Anschlüssen einer weiteren Vorrichtung verbindbar sind.

Die einzelnen Einrichtungen zum Erfassen von Informationen (z. B. Sensoren) senden gemäß der Erfindung eine eindeutige Identifikationsinformation (ID), anhand derer die Vorrichtung nach dem ersten Aspekt die Informationen, insbesondere bei seriellem Anschluss von Vorrichtung(en) nach dem zweiten Aspekt an einer Vorrichtung nach dem ersten Aspekt, identifizieren und beispielsweise einer Messaufgabe zuordnen kann. Derartige eindeutige Identifikationsinformation können beispielsweise von den seitens der jeweiligen Vorrichtung nach dem ersten Aspekt ausgegeben Informationen umfasst oder repräsentiert sein.

In einer Ausgestaltung nach dem zweiten Aspekt des Gegenstands umfasst die Vorrichtung ferner:
- Mittel zum Konvertieren (z. B. Wandeln) einer analogen Information in eine digitale Information (z. B. Analog/Digital Wandler), wobei mittels der Mittel zum Wandeln einer analogen Information in eine digitale Information von der einen oder den mehreren Einrichtungen zum Erfassen von Informationen erfasste Informationen konvertierbar sind.

Jede Einrichtung zum Erfassen von Informationen (z. B. ein Sensor und/oder ein Drehstromsensor (z. B. umfassend drei Sensoren in einem Sensorgehäuse/Erfassungsmodul)) wird von der (z. B. zentralen) Vorrichtung nach dem ersten Aspekt (z. B. Auswerte-/Kommunikationseinheit) mit einer Hilfsspannung versorgt, z. B. über entsprechende Anschlüsse umfasst von der Vorrichtung nach dem zweiten Aspekt. Dadurch, dass nicht die analogen sondern digital gewandelte Werte von der Vorrichtung nach dem zweiten Aspekt (z. B. Sensor) an die Vorrichtung nach dem ersten Aspekt (z. B. Auswerte-/Kommunikationseinheit) übermittelt werden, wird auf dem Signal weg zwischen Sensor und Auswerte-/Kommunikationseinheit eine Manipulation erschwert

In einer Ausgestaltung nach dem zweiten Aspekt des Gegenstands umfasst die Vorrichtung ferner:
- mindestens eine Kommunikationsschnittstelle, wobei die eine oder mehrere Informationen, die erfasst wurden, über die mindestens eine Kommunikationsschnittstelle ausgebbar sind.

In einer Ausgestaltung nach dem zweiten Aspekt des Gegenstands sind die eine oder mehrere Informationen, die erfasst wurden, verschlüsselt über die mindestens eine Kommunikationsschnittstelle ausgebbar.

Die jeweilige Kommunikationsschnittstelle der Vorrichtung nach dem ersten und/oder zweiten Aspekt kann beispielsweise eine verschlüsselte Kommunikation ermöglichen. Beispielsweise können Informationen (z. B. Messwerte in Form von Daten oder Datenpaketen) über eine Datenleitung zusätzlich oder alternativ verschlüsselt übermittelt werden. Hierfür eigenen sich regelmäßige Verschlüsselungsverfahren nach definierten Standards, wie etwa Ende-zu-Ende, Transport Layer Security (TLS), Secure Sockets Layer (SSL) Verschlüsselungen, um nur einige nicht-limitierende Beispiele zu nennen.

Beispielsweise umfasst die Vorrichtung (nach dem zweiten Aspekt) ferner Mittel zum Speichern von erfassten Informationen. In diesen können beispielsweise erfasste Informationen bis zum Senden über die mindestens eine Kommunikationsschnittstelle (z. B. zwischen-) gespeichert werden.

In einer Ausgestaltung nach dem ersten Aspekt des Gegenstands umfasst (oder weist) die Vorrichtung mindestens drei Einrichtungen zum Erfassen von Informationen (auf), so dass eine oder mehrere elektrische Größen von mindestens drei Phasenwechselspannungen erfassbar sind.

Beispielsweise können derart immer drei Einrichtungen zum Erfassen von Informationen (z. B. Sensoren) in einem Gehäuse zusammen verbaut sein, so dass beispielsweise ein Drehstromsensor von den Komponenten umfasst in diesem einen Gehäuse realisiert ist. Derart können ferner die Einrichtungen zum Erfassen von Informationen (z. B. Sensoren) in einer Stückelung von 3, 6, 9, usw. an eine von diesen separierte bzw. getrennte Vorrichtung nach dem ersten Aspekt (z. B. eine Auswerte- und/oder Kommunikationseinheit) angeschlossen werden. Ebenso können einphasige Sensoren (Wechselstromsensoren) realisiert sein, indem eine Einrichtung zum Erfassen von Informationen (z. B. Sensor) in einem Gehäuse zusammen verbaut ist. Ferner können derartige einphasige Sensoren (Wechselstromsensoren) zusammen mit vorstehend offenbarten Drehstromsensoren an einer Vorrichtung nach dem ersten Aspekt angeschlossen und parallel betrieben werden.

Die zuvor in dieser Beschreibung beschriebenen beispielhaften Ausgestaltungen der vorliegenden Erfindung sollen auch in allen Kombinationen miteinander offenbart verstanden werden. Insbesondere sollen beispielhafte Ausgestaltungen in Bezug auf die unterschiedlichen Aspekten offenbart verstanden werden.

Insbesondere sollen durch die vorherige oder folgende Beschreibung von Verfahrensschritten gemäß bevorzugter Ausführungsformen eines Verfahrens auch entsprechende Mittel zur Durchführung der Verfahrensschritte durch bevorzugte Ausführungsformen einer Vorrichtung offenbart sein. Ebenfalls soll durch die Offenbarung von Mitteln einer Vorrichtung zur Durchführung eines Verfahrensschrittes auch der entsprechende Verfahrensschritt offenbart sein.

Weitere vorteilhafte beispielhafte Ausgestaltungen der Erfindung sind der folgenden detaillierten Beschreibung einiger beispielhafter Ausführungsformen der vorliegenden Erfindung, insbesondere in Verbindung mit den Figuren, zu entnehmen. Die Figuren sollen jedoch nur dem Zwecke der Verdeutlichung, nicht aber zur Bestimmung des Schutzbereiches der Erfindung dienen. Die Figuren sind nicht maßstabsgetreu und sollen lediglich das allgemeine Konzept der vorliegenden Erfindung beispielhaft widerspiegeln. Insbesondere sollen Merkmale, die in den Figuren enthalten sind, keineswegs als notwendiger Bestandteil der vorliegenden Erfindung erachtet werden.

### Kurze Beschreibung der Figuren

In der Zeichnung zeigt
- Fig. 1: eine schematisches Blockdiagramm einer beispielhaften Ausgestaltung von einem gegenständlichen System nach dem dritten Aspekt;
- Fig. 2: ein weiteres schematisches Blockdiagramm einer beispielhaften Ausgestaltung von einem System nach dem dritten Aspekt;
- Fig. 3a, b: jeweils ein schematisches Blockdiagramm einer spezifischen Verbindungsvariante eines Systems nach dem dritten Aspekt;
- Fig. 4: eine bespielhafte Ausgestaltung einer Montageanordnung eines Systems nach dem dritten Aspekt; und
- Fig. 5: ein schematisches Blockdiagramm von einem aus dem Stand der Technik bekannter digitalen Stromzähler.

### Detaillierte Beschreibung einiger beispielhafter Ausführungsformen der Erfindung

Der vorliegende Gegenstand wird im Folgenden anhand von beispielhaften Ausführungsformen beschrieben.

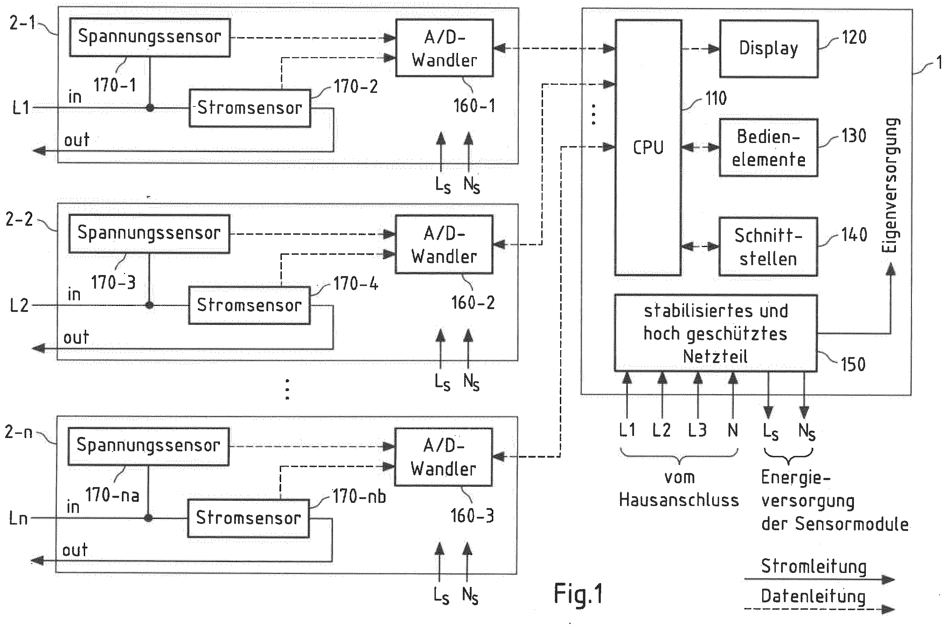

Fig. 1 illustriert eine Vorrichtung nach dem ersten Aspekt, eine Auswerte- und/oder Kommunikationseinheit 1, die von einem System nach dem dritten Aspekt umfasst ist. Das System nach dem dritten Aspekt umfasst vorliegend ferner Vorrichtungen 2 nach dem zweiten Aspekt, jeweils ein Sensormodul 2-1 bis 2-n, die ebenfalls von dem System nach dem dritten Aspekt umfasst sind. Illustriert sind drei solcher Sensormodule.

Die Auswerte- und/oder Kommunikationseinheit 1 umfasst eine Stromversorgungseinrichtung 150, die als ein stabilisiertes und hochgeschütztes Netzteil ausgebildet ist. Die Auswerte- und/oder Kommunikationseinheit 1 umfasst ferner eine Einrichtung zum Auswerten und/oder Speichern von Informationen, vorliegend einen Prozessor 110, der beispielsweise einen Speicher (in Fig. 1 nicht dargestellt) zum Speichern von empfangenen Informationen (z. B. von einem oder mehreren der Sensormodule 2-1 bis 2-3) umfasst oder mit einem derartigen Speicher, der von der Auswerte- und/oder Kommunikationseinheit 1 umfasst ist, operativ (z. B. elektrisch) verbindbar bzw. verbunden ist.

Die Stromversorgungseinrichtung 150 weist ferner einen Abgang auf, der mit Eigenversorgung bezeichnet ist. Die Stromversorgungseinrichtung 150 speist über diesen Abgang beispielsweise die Komponenten Prozessor 110, Display 120, Bedienelemente 130, Schnittstellen 140 mit zum Betrieb notwendiger elektrischer Energie.

Die Auswerte- und/oder Kommunikationseinheit 1 umfasst eine Anzeigeeinrichtung in Form eines Displays 1. Ferner umfasst die Auswerte- und/oder Kommunikationseinheit 1 Eingabemittel, die beispielsweise Bedienelemente 130 wie Tasten sein können. Alternativ oder zusätzlich können derartige Eingabemittel von dem Display 120 in Form eines berührungsempfindlichen Displays 120, um nur ein nicht-limitierendes Beispiel zu nennen, umfasst sein.

Die Auswerte- und/oder Kommunikationseinheit 1 umfasst ferner eine oder mehrere Schnittstellen 140, insbesondere eine Kommunikationsschnittstelle. Alternativ oder zusätzlich ist die Einrichtung zum Auswerten und/oder Speichern von Informationen 110 zum Empfang von einer oder mehreren Informationen, die von zumindest einem der Sensormodule 2-1 bis 2-n an die Auswerte- und/oder Kommunikationseinheit 1 gesendet werden, ausgebildet und/oder eingerichtet.

Das System gemäß dem dritten Aspekt nach Fig. 1 zeigt schematisch die Möglichkeit, dass beliebig viele von beispielhaft dargestellten Vorrichtungen 2 bzw. Sensormodule 2 nach dem zweiten Aspekt mit einer (einzigen) Vorrichtung 1 nach dem ersten Aspekt verbindbar sind, bzw. verbunden werden können. Dies ist durch die Nummerierung der dargestellten Sensormodule von 2-1, 2-2 bis hin zu 2-n Sensormodulen illustriert und hier beschrieben.

Die Sensormodule 2-1 bis 2-n umfassen vorliegend jeweils zwei Sensoren 170 als Einrichtungen zum Erfassen von Informationen, wobei ein Sensor zum Erfassen der elektrischen Größe einer Spannung (z. B. Sensoren 170-1, 170-3, 170-na), und ein weiterer Sensor zum Erfassen der elektrischen Größe eines Stroms ausgebildet ist (vgl. Sensoren 170-2, 170-4, 170-nb). Es versteht sich, dass eine jeweilige Vorrichtung 2 auch nur einen Sensor, oder aber auch mehr als die illustrierten zwei Sensoren umfassen kann.

Die Sensormodule 2-1 bis 2-n umfassen vorliegend jeweils einen A/D-Wandler 160-1, 160-2, 160-n zum Konvertieren bzw. Wandeln von analogen Daten bzw. Informationen der jeweiligen Sensoren 170-1, 170-2, 170-3, 170-4, 170-na, 170-nb in digitale Informationen bzw. digitale (Mess-) Werte. Nach dem Konvertieren bzw. Wandeln erfolgt eine Ausgabe bzw. ein Veranlassen einer Ausgabe (z. B. ein Senden) der konvertierten bzw. gewandelten und/oder gegebenenfalls verschlüsselten Informationen an die Auswerte- und/oder Kommunikationseinheit 1.

Das Konvertieren bzw. Wandeln von analogen Informationen, die beispielsweise Messwerte repräsentieren, in digitale Informationen erschwert beispielsweise Manipulationsmöglichkeiten, da digitale Informationen beispielsweise schwerer nachträglich verändert werden können. Als Beispiel sei an dieser Stelle die Möglichkeit genannt, beispielsweise durch Elektromagnetismus analog übertragene Informationen während der Übertragung beispielsweise in ihrer Amplitude oder dergleichen verändern zu können.

In Fig. 1 ist illustriert, dass das Netzteil 150 von einem Anschluss, beispielsweise ein Hausanschluss als definiertem Übergabepunkt zwischen einem Energieversorger und einem elektrische Energie beziehenden Haushalt, in dem beispielsweise das System nach dem dritten Aspekt installiert bzw. angeordnet ist, elektrische Energie, vorliegend in Form von Dreiphasenwechselspannung über die Leiter bzw. Anschlüsse L1, L2, L3, N erhält. Abgehend ist ferner illustriert, dass zwei Rückleiter, die mit Lₛ und Nₛ bezeichnet sind, von dem Netzteil 150 zu jedem der Sensormodule 2-1 bis 2-n führen. Hierüber werden die Sensormodule 2-1 bis 2-n von der Auswerte- und/oder Kommunikationseinheit 1 mit zum Betrieb notwendiger elektrischer Energie versorgt. Die Sensormodule 2-1 bis 2-n weisen folglich keine eigene Stromversorgungseinheit in irgendeiner Form auf.

Seitens der Auswerte- und/oder Kommunikationseinheit 1 von den Sensormodule 2-1 bis 2-n erfassten Informationen (z. B. repräsentierend jeweils erfasste Strom- und/oder Spannungsmesswerte) können über die Kommunikationsschnittstelle 140 an weitere Entitäten, die in Fig. 1 nicht dargestellt sind, ausgegeben werden. Dies können beispielsweise ein Server, eine Server-Cloud oder ein Gateway sein, so dass es möglich ist, die Informationen beispielsweise ortsunabhängig (z. B. über einen Computer und über das Internet) abzufragen, um nur ein nicht-limitierendes Beispiel zu nennen.

Im deutschen Markt gibt es z. B. klare Vorgaben für derartige Gateways, die beispielsweise den Inhalt der Informationen, die dieses erhält, definieren. Der Gegenstand nach allen Aspekten ermöglicht es, dass derartige Gateways zur Kompatibilität nicht verändert werden müssen. Hierzu ist der Gegenstand nach allen Aspekten kompatibel zu bekannten standardisierten Schnittstellen an derartigen Gateways. Beispielsweise werden die Informationen seitens der Auswerte- und/oder Kommunikationseinheit 1 derart aufbereitet, dass diese im Bedarfsfall vor einer Ausgabe über die Kommunikationsschnittstelle 140 die definierten Vorgaben erfüllen. Derart sind die dann übertragenen bzw. ausgegebenen Informationen mit derartigen Gateways konform. Folglich müssen derartige und mitunter bereits installierte Gateways nicht geändert werden, weder hardware- noch softwareseitig.

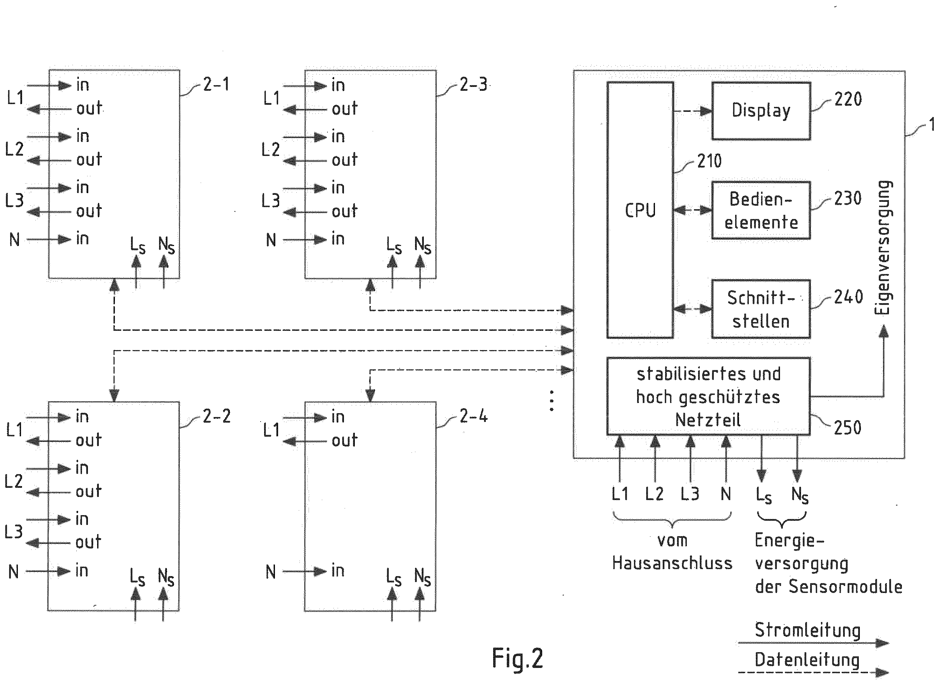

Fig. 2 zeigt ein weiteres schematisches Blockdiagramm einer beispielhaften Ausgestaltung von einem System nach dem dritten Aspekt.

Das System nach Fig. 2 umfasst vorliegend vier Sensormodule 2-1 bis 2-4, sowie eine (einzige) Auswerte- und/oder Kommunikationseinheit 1.

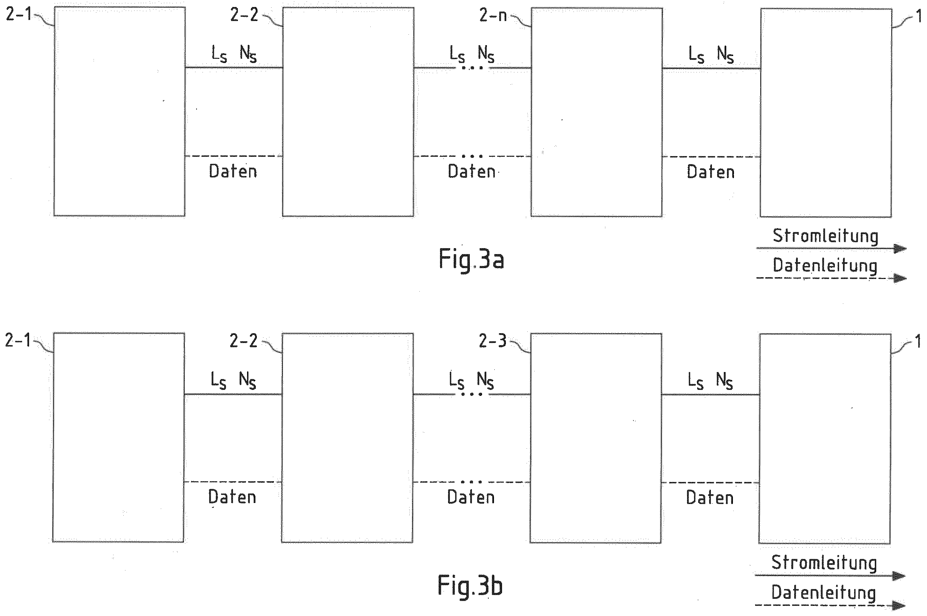

Fig. 1 zeigt die generelle Funktionsweise von einem System nach dem dritten Aspekt, die auch auf das in Fig. 2 (und Fig. 3a, 3b) gezeigte gegenständliche System nach dem dritten Aspekt zutrifft (bzw. zutreffen).

Es ist explizit gezeigt, dass jedes der Sensormodule 2-1 bis 2-4 eine Verbindung zu der Auswerte- und/oder Kommunikationseinheit 1 aufweist. Jede der Verbindungen der Sensormodule 2-1 bis 2-4 zu der Auswerte- und/oder Kommunikationseinheit 1 ist dabei unabhängig voneinander. Dies kann beispielsweise über eine jeweils separierte (z. B. Daten-) Leitung von einem entsprechenden Sensormodul 2-1 bis 2-n zu der Auswerte- und/oder Kommunikationseinheit 1 realisiert sein. Alternativ oder zusätzlich kann dies beispielsweise mit einem Kabel realisiert sein, dass beispielsweise für jedes der entsprechenden Sensormodule 2-1 bis 2-4 eine oder mehrere Adern zum Übertragen von Informationen zwischen einem entsprechenden Sensormodul 2-1 bis 2-4 zu der Auswerte- und/oder Kommunikationseinheit 1 aufweist, um nur einige nicht-limitierende Beispiele zu nennen.

Ferner ist in Fig. 2 zu erkennen, dass jedes der Sensormodule mehrere Anschlüsse L1, L2, L3, N umfassen kann, um entsprechend elektrische Größen erfassen (z. B. messen) zu können. Hierzu kann ein jedes der gezeigten Sensormodule 2-1 bis 2-4 beispielsweise zumindest einen Spannungs- und einen Stromsensor (analog zu den Sensoren 170-1, 170-2, 170-3, 170-4, 170-na, 170-nb der Fig. 1) umfassen.

Die Sensormodule 2-1 bis 2-3 sind beispielsweise als Drehstromsensoren ausgebildet, so dass ein jeder dieser drei Sensormodule 2-1 bis 2-3 beispielsweise alle drei Phasen eines Drehstroms erfassen kann. In diesem Fall umfasst ein entsprechendes Sensormodul 2-1, 2-2, 2-3 jeweils mehrere Anschlüsse L1, L2, L3, sowie N. Das Sensormodul 2-4 ist beispielsweise als Wechselstromsensor ausgebildet, so dass beispielsweise nur eine Phase eines Drehstromsystems erfasst wird. In diesem Fall umfasst das Sensormodul 2-4 den Anschluss L1.

Fig. 3a und b zeigen jeweils ein schematisches Blockdiagramm einer spezifischen Verbindungsvariante eines Systems nach dem dritten Aspekt.

Im Gegensatz zu Fig. 2 umfasst das System gemäß dem dritten Aspekt nach den Fig. 3a und 3b mehrere Sensormodule, die seriell nach der Art eines Bussystems miteinander verbunden sind. Die Auswerte- und/oder Kommunikationseinheit 1 weist folglich nicht jeweils eine dedizierte Verbindung zu jedem der Sensormodule auf, sondern nur eine dedizierte Verbindung zu einem der Sensormodule. Anschließend ist jeweils ein weiteres Sensormodul mit einem weiteren (untereinander) verbunden. Informationen werden von einem jeweiligen Sensormodul an die Auswerte- und/oder Kommunikationseinheit 1 beispielsweise jeweils von einem "näher" an der Auswerte- und/oder Kommunikationseinheit 1 gelegenen Sensormodul weitergeleitet, bis die entsprechenden Informationen von der Auswerte- und/oder Kommunikationseinheit 1 empfangen sind.

Um beispielsweise die empfangenen Informationen unterscheiden zu können, insbesondere um zuordnen zu können, welches Sensormodul die entsprechenden Informationen erfasst hat, kann ein jedes der Sensormodule vor der Ausgabe der Informationen diese beispielsweise mit einem Identifier assoziieren oder die Informationen mit einem derartigen Identifier versehen, so dass die Informationen einen derartigen Identifier umfassen oder repräsentieren.

Dass mehrere Sensormodule mittels eines beispielhaften Bussystems mit einer Auswerte- und/oder Kommunikationseinheit 1 verbunden werden können, ist in Fig. 3a illustriert, indem zwei Sensormodule 2-1, 2-2 über 2-n weitere Sensormodule mit der gezeigten Auswerte- und/oder Kommunikationseinheit 1 verbunden sind.

In Fig. 3b ist das Prinzip exemplarisch für drei Sensormodule 2-1 bis 2-3 illustriert. Informationen, die beispielsweise von dem Sensormodul 2-1 erfasst wurden, werden zur Übermittlung an die Auswerte- und/oder Kommunikationseinheit 1 zunächst an das Sensormodul 2-2, welches wiederrum die Informationen an das Sensormodul 2-3 weiterleitet. Abschließend leitet das Sensormodul 2-3, dass eine direkte Verbindung zu der Auswerte- und/oder Kommunikationseinheit 1 aufweist, die ursprünglich von dem Sensormodul 2-1 stammenden Informationen an Auswerte- und/oder Kommunikationseinheit 1.

Dabei ist es egal, welche Messfunktion bzw. Messaufgabe ein jeweiliges Sensormodul erfüllt. Beispielsweise ist das Sensormodul 2-1 der Fig. 3b als Drehstromsensormodul ausgebildet, ebenso wie das Sensormodul 2-3. Das Sensormodul 2-2 der Fig. 3b ist beispielsweise als Wechselstromsensormodul ausgebildet.

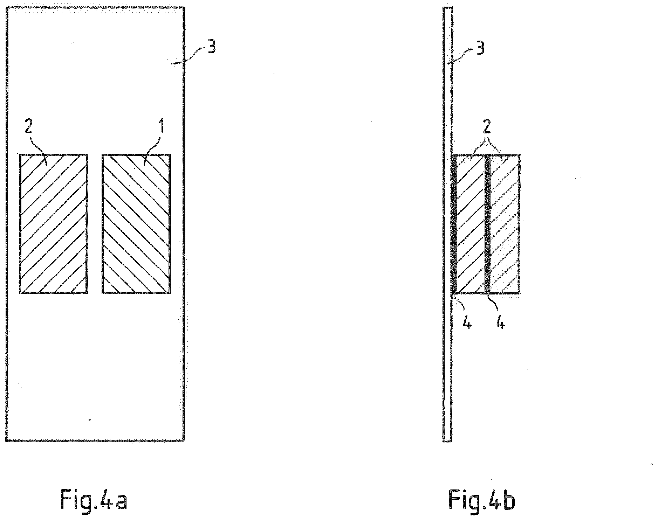

Fig. 4 zeigt eine bespielhafte Ausgestaltung einer Montageanordnung eines Systems nach dem dritten Aspekt.

Die Tragplatten 3 sind beispielsweise Zählertragplatten, die in Fig. 4a in einer Frontansicht, und in Fig. 4b in einer Seitenansicht gezeigt sind. Auf einer derartigen Zählertragplatte 3 können eine Auswerte- und/oder Kommunikationseinheit 1 und eine oder mehrere Sensormodule 2 angeordnet werden. Derartige Zählertragplatten können beispielsweise in einem Zählerschrank (in Fig. 4a, b nicht dargestellt) angeordnet werden.

Derartige Zählerschränke sind beispielsweise normiert. Es gibt z. B. unterschiedliche Formen. Das System nach dem dritten Aspekt, bzw. die von einem System nach dem dritten Aspekt umfasste Vorrichtung 1 nach dem ersten Aspekt, und eine oder mehrere Vorrichtungen 2 nach dem zweiten Aspekt passen beispielsweise genau auf technische Beschreibungen der Zählerplätze. Beispielsweise ist ein Gehäuse, dass die Vorrichtungen nach dem ersten und/oder zweiten Aspekt umfasst, derart ausgestaltet, dass es (jeweils) auf einen derartigen Zählerplatz passt, indem es die seitens einer Norm definierten Aufnahmepunkte und/oder Abmessungen erfüllt, um nur einige nicht-limitierende Beispiele zu nennen.

Die Aufnahme ist beispielsweise eine sogenannte elektronischer Haushaltszähler (eHZ) Aufnahme. Es gibt auch andere Aufnahmen, so dass das Beispiel der eHZ für den Gegenstand nach allen Aspekten nicht beschränkend ist. Die Vorrichtungen nach dem ersten und/oder zweiten Aspekt erfüllen beispielsweise standardisierte Befestigungsmöglichkeiten, so dass z. B. eine Kompatibilität zu umgebenden Systemen (wie etwa einem genormten Zählerschrank) gewährleistet ist. Ein derartiger eHZ weist beispielsweise eine sogenannte 3-Punkt-Befestigung auf.

In Fig. 4b ist eine sogenannte Huckepack-Installation eines gegenständlichen Systems nach dem dritten Aspekt gezeigt. Hierbei sind ein oder mehrere Sensormodule 2 übereinander angeordnet. Hierzu kann beispielsweise eine schematisch illustrierte Adapterplatte 4 eingesetzt werden. Es können beispielsweise drei Sensormodule in einer Ebene liegend angeordnet werden, so dass beispielsweise ein Standard-Zähleranschluss für einen Haushalt realisiert ist. Über die Adapterplatte, die beispielsweise zu der oben beschriebenen 3-Punkt-Befestigung eines eHZs passt, können derart mehrere Sensormodule übereinander angeordnet werden.

Ein Beispiel eines Anwendungsfalls ist ein Mehrfamilienhaus. Beispielsweise umfasst ein dort installierter Zählerschrank zwei Vorrichtungen 2 nach dem zweiten Aspekt zu jeweils einer verschiedenen Partei des Mehrfamilienhauses. Ferner umfasst dieser Zählerschrank dann lediglich eine Vorrichtung 1 nach dem ersten Aspekt. Eine Unterscheidung der Informationen, z. B. Verbrauchsinformation von elektrischer Energie einer jeweiligen Partei ist dann beispielsweise durch IDs der Sensormodule möglich.

Ein derartiges System nach dem dritten Aspekt wird vorliegend auch als Multi-Modaler Meter bezeichnet. Durch den Einsatz von Multi-Modalen Metern mit der Trennung von Sensormodulen (Vorrichtung(en) nach dem zweiten Aspekt) umfassend z. B. einen oder mehrere Sensoren, und einer Auswerte-/Kommunikationseinheit (Vorrichtung nach dem ersten Aspekt) sind auch andere Zählerschrankdesigns möglich. So können die Sensormodule in einer Ausführungsform auch übereinander montiert werden, um eine höhere Packungsdichte und damit kleinere Zählerschrankvolumina zu erreichen.

Außer zur Bestimmung aller Zählwerte für eine rechtliche Person (Haushalts-, PV- und Batteriestrom, um nur ein nicht-limitierendes Beispiel zu nennen) kann ein gegenständlicher Multi-Modaler Meter (z. B. repräsentiert durch ein System nach dem dritten Aspekt) ebenfalls immer dort zum Einsatz kommen, wo an einem Ort beispielsweise mehrere Ströme und Spannungen gemessen werden müssen. Dies kann z. B. in einer Ausführung der Idee auch im Zählerschrank eines Mehrfamilienhauses der Fall sein. Alle n-Wohnungen/Haushalte können über beispielsweise n x 3 Sensoren gemessen und einer einzigen Auswerte-/Kommunikationseinheit zugeführt werden. Über ein Berechtigungskonzept kann jeder Haushalt sowohl am Display sowie an der Datenschnittstelle nur die eigenen Messwerte auslesen. Dies kann z. B. durch Eingabe eines PIN-Codes, eines Tokens, eines elektronischen Schlüssels einer eingelesenen Chip-Karte oder ähnlich realisiert werden.

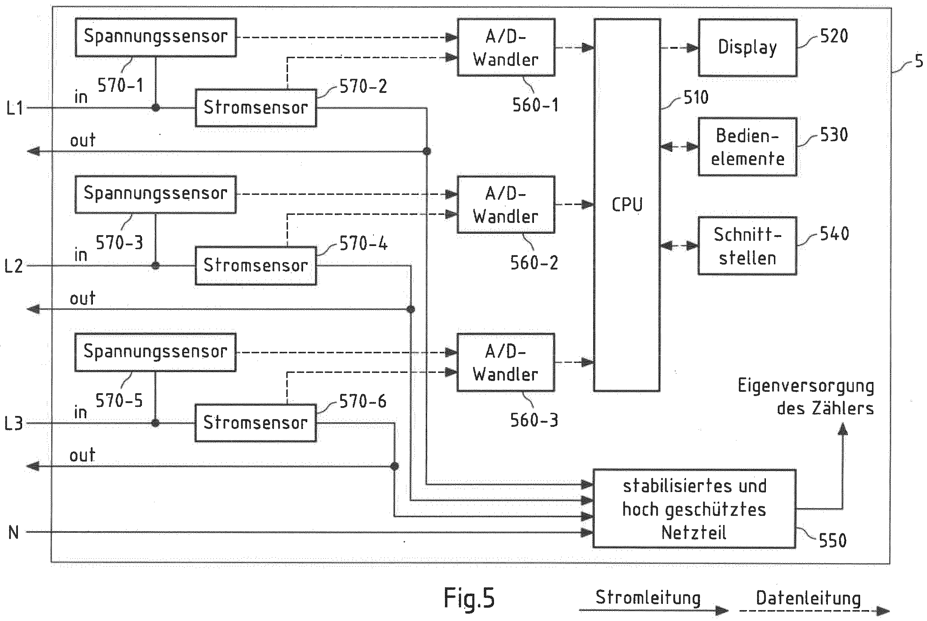

Fig. 5 zeigt ein schematisches Blockdiagramm von einem aus dem Stand der Technik bekannten digitalen Stromzähler 5. Es ist zu erkennen, dass ein derartiger Zähler 5 nahezu sämtliche Komponenten, die auch ein gegenständliches System nach dem dritten Aspekt umfasst, aufweist. Ein derartiger Zähler 5 nach Fig. 5 ist jedoch nicht erweiterbar. Ferner ist ein derartiger Zähler 5 nach Fig. 5 auf die von dem Zähler umfassten Sensoren 570 limitiert. Werden in einem Anwendungsfall mehr Sensoren als die von einem derartigen Zähler 5 nach Fig. 5 umfassten Sensoren 570 benötigt, muss ein weiterer Zähler nach Fig. 5 gemäß Stand der Technik eingesetzt werden. Viele Komponenten sind dann doppelt vorhanden, obwohl dies nicht notwendig ist. Dies trifft z. B. in einem Mehrfamilienhaus zu. Neben dann unnötig zum Verbrauch benötigter elektrischer Energie, z. B. für redundante Displays, benötigen derartige Zähler nach Fig. 5 auch wesentlich mehr Installationsplatz. Nachteilig an derartigen Zählern nach Fig. 5 ist ferner, dass die Sensoren 570 in unmittelbarer Nähe zu dem Netzteil 550 angeordnet sind. Um beispielsweise Messwerte wie Strom und/oder Spannung genau erfassen zu können, muss eine gute Abschirmung dieser Komponenten erfolgen, insbesondere um elektrische Einflüsse (z. B. durch Elektromagnetismus) von weiteren innerhalb desselben Gehäuses angeordneter Komponenten (z. B. Netzteil 550) vermindern bzw. reduzieren zu können. Dies resultiert in hohe Kosten für derartige diese Abschirmung beispielsweise ermöglichenden Komponenten. Diese Probleme bzw. Nachteile werden durch den Gegenstand gemäß allen Aspekten wesentlich reduziert bzw. sogar vermieden.

Die in dieser Spezifikation beschriebenen Ausführungsbeispiele der vorliegenden Erfindung und die diesbezüglich jeweils angeführten optionalen Merkmale und Eigenschaften sollen auch in allen Kombinationen miteinander offenbart verstanden werden. Insbesondere soll auch die Beschreibung eines von einem Ausführungsbeispiel umfassten Merkmals - sofern nicht explizit gegenteilig erklärt - vorliegend nicht so verstanden werden, dass das Merkmal für die Funktion des Ausführungsbeispiels unerlässlich oder wesentlich ist. Die Abfolge der in dieser Spezifikation geschilderten Verfahrensschritte in den einzelnen Ablaufdiagrammen ist nicht zwingend, alternative Abfolgen der Verfahrensschritte sind denkbar. Die Verfahrensschritte können auf verschiedene Art und Weise implementiert werden, so ist eine Implementierung in Software (durch Programmanweisungen), Hardware oder eine Kombination von beidem zur Implementierung der Verfahrensschritte denkbar.

In den Patentansprüchen verwendete Begriffe wie "umfassen", "aufweisen", "beinhalten", "enthalten" und dergleichen schließen weitere Elemente oder Schritte nicht aus. Unter die Formulierung "zumindest teilweise" fallen sowohl der Fall "teilweise" als auch der Fall "vollständig". Die Formulierung "und/oder" soll dahingehend verstanden werden, dass sowohl die Alternative als auch die Kombination offenbart sein soll, also "A und/oder B" bedeutet "(A) oder (B) oder (A und B)". Die Verwendung des unbestimmten Artikels schließt eine Mehrzahl nicht aus. Eine einzelne Vorrichtung kann die Funktionen mehrerer in den Patentansprüchen genannten Einheiten bzw. Vorrichtungen ausführen. In den Patentansprüchen angegebene Bezugszeichen sind nicht als Beschränkungen der eingesetzten Mittel und Schritte anzusehen.

### Bezugszeichenliste

- 1: Auswerte- und/oder Kommunikationseinheit
- 2: Sensormodul
- 3: Tragplatte
- 4: Adapter
- 110: Prozessor
- 120: Anzeigeeinrichtung
- 130: Eingabemittel
- 140: (Kommunikations-) Schnittstelle
- 150: Stromversorgungseinrichtung
- 160: A/D-Wandler
- 170: Sensor
- 210: Prozessor
- 220: Anzeigeeinrichtung
- 230: Eingabemittel
- 240: (Kommunikations-) Schnittstelle
- 250: Stromversorgungseinrichtung
- 510: Prozessor
- 520: Anzeigeeinrichtung
- 530: Eingabemittel
- 540: (Kommunikations-) Schnittstelle
- 550: Stromversorgungseinrichtung
- 560: A/D-Wandler
- 570: Sensor

## Patentansprüche

1. System umfassend
- eine Auswerte- und Kommunikationseinheit (1) sowie ein oder mehrere Sensormodule (2) zum Erfassen von Informationen;
- wobei die Auswerte- und Kommunikationseinheit (1) umfasst:
- mindestens eine Stromversorgungseinrichtung (150, 250) und
- eine Einrichtung zum Auswerten und/oder Speichern von Informationen (110, 210);
- und wobei das eine oder die mehreren Sensormodule (2) umfassen:
- eine oder mehrere Einrichtungen zum Erfassen von Informationen (170, 270);
- wobei die eine oder mehreren Einrichtungen zum Erfassen von Informationen (170, 270) seitens der mindestens einen Stromversorgungseinrichtung (150, 250) mit elektrischer Energie versorgbar sind,
- wobei mittels der einen oder mehreren Einrichtungen zum Erfassen von Informationen Informationen (170) erfassbar sind, wobei die erfassten Informationen indikativ für eine oder mehrere elektrisch erfassbare Größen sind, und wobei die erfassten Informationen von dem einen oder den mehreren Sensormodulen sendbar sind,
- wobei die Informationen von der Auswerte- und Kommunikationseinheit (1) empfangbar sind,
- wobei die Auswerte- und Kommunikationseinheit (1) von dem einen oder den mehreren Sensormodulen (2) separiert ist,
**dadurch gekennzeichnet,**
- **dass** die Einrichtung zum Auswerten und/oder Speichern von Informationen (110, 210) ferner dazu konfiguriert ist, eine Pairing-Information zu speichern, wobei die Pairing-Information eine Assoziierung der Auswerte- und Kommunikationseinheit (1) zu einem definierten Sensormodul (2) der einen oder mehreren Sensormodule (2) repräsentiert, so dass keine Informationen von Sensormodulen (2) empfangbar sind, die nicht gemäß der entsprechenden Pairing-Information definiert sind, und
- **dass** das eine oder die mehreren Sensormodule (2) eine eindeutige Identifikationsinformation senden, anhand derer die Auswerte- und Kommunikationseinheit (1) die Information identifiziert und einer Messaufgabe zuordnet.

2. System nach Anspruch 1, wobei die mindestens eine Stromversorgungseinrichtung (150, 250) mit der einen oder den mehreren Sensormodulen (2) zum Erfassen von Informationen elektrisch verbindbar ist, so dass elektrische Energie von der mindestens einen Stromversorgungseinrichtung (150, 250) an die eine oder mehreren Sensormodule (2) zum Erfassen von Informationen übertragbar ist.

3. System nach Anspruch 1 oder 2, wobei die Auswerte- und Kommunikationseinheit (1) ferner umfasst:
- mindestens eine Kommunikationsschnittstelle (140, 240), wobei die einen oder mehreren Informationen, die empfangen wurden, über die mindestens eine Kommunikationsschnittstelle (140, 240) ferner ausgebbar sind.

4. System nach Anspruch 3, wobei die eine oder mehrere Informationen, die empfangen wurden, verschlüsselt über die Kommunikationsschnittstelle (140, 240) ausgebbar sind.

5. System nach einem der vorhergehenden Ansprüche, wobei jeweils eine Datenverbindung von der Auswerte- und Kommunikationseinheit (1) zu dem einen oder den mehreren Sensormodulen (2) zum Erfassen von Informationen herstellbar ist oder besteht

6. System nach einem der vorhergehenden Ansprüche, wobei die Auswerte- und Kommunikationseinheit (1) ferner umfasst:
- mindestens einen Anschluss für eine Stromleitung; und
- mindestens einen Anschluss für eine Datenleitung;
wobei der mindestens eine Anschluss für die Stromleitung und/oder der mindestens eine Anschluss für die Datenleitung mit korrespondierenden Anschlüssen des einen oder der mehreren Sensormodule (2) zum Erfassen von Informationen jeweils verbindbar sind.

7. System nach einem der vorhergehenden Ansprüche, wobei die Einrichtung zum Auswerten und/oder Speichern von Informationen (110, 210) konfiguriert ist, empfangene eine oder mehrere Informationen weiter zu verarbeiten.

8. System nach einem der Ansprüche 1 bis 7, wobei das eine oder die mehreren Sensormodule (2) ferner umfasst:
- mindestens einen Anschluss für eine Stromleitung; und
- mindestens einen Anschluss für eine Datenleitung;
wobei der mindestens eine Anschluss für die Stromleitung und/oder der mindestens eine Anschluss für die Datenleitung mit korrespondierenden Anschlüssen einer weiteren Auswerte- und Kommunikationseinheit (1) verbindbar sind.

9. System nach einem der Ansprüche 1 bis 8, wobei das eine oder die mehreren Sensormodule (2) ferner umfasst:
- Mittel zum Konvertieren (160) einer analogen Information in eine digitale Information, wobei mittels der Mittel zum Wandeln (160) einer analogen Information in eine digitale Information von der einen oder den mehreren Einrichtungen zum Erfassen von Informationen (170) erfasste Informationen konvertierbar sind.

10. System nach einem der Ansprüche 1 bis 9, wobei das eine oder die mehreren Sensormodule (2) ferner umfasst:
- mindestens eine Kommunikationsschnittstelle, wobei die eine oder mehrere Informationen, die erfasst wurden, über die mindestens eine Kommunikationsschnittstelle ausgebbar sind.

11. System nach Anspruch 10, wobei die eine oder mehrere Informationen, die erfasst wurden, verschlüsselt über die mindestens eine Kommunikationsschnittstelle ausgebbar sind.

12. System nach einem der Ansprüche 1 bis 11, wobei das Sensormodul (2) mindestens drei Einrichtungen zum Erfassen von Informationen (170-1 bis 170-3) umfasst, so dass eine oder mehrere elektrische Größen von mindestens drei Phasenwechselspannungen erfassbar sind.

## Claims

1. System, comprising
- an evaluation and communication unit (1) and one or more sensor modules (2) for detecting information pieces;
- wherein the evaluation and communication unit (1) comprises:
- at least one power supply device (150, 250) and
- a device for evaluating and/or storing information pieces (110, 210);
- and wherein the one or more sensor modules (2) comprise:
- one or more devices for detecting information pieces (170, 270);
- wherein the one or more devices for detecting information pieces (170, 270) care suppliable with electrical energy by the at least one power supply device (150, 250),
- wherein information pieces (170) are detectable by means of the one or more information detection devices, wherein the detected information pieces are indicative of one or more electrically detectable variables, and wherein the detected information pieces are transmittable by the one or more sensor modules,
- wherein the information pieces are receivable by the evaluation and communication unit (1),
- wherein the evaluation and communication unit (1) is separated from the one or more sensor modules (2),
**characterized in that**
- that the device for evaluating and/or storing information (110, 210) is further configured to store a pairing information piece, wherein the pairing information piece represents an association of the evaluation and communication unit (1) with a defined sensor module (2) of the one or more sensor modules (2), so that no information pieces are receivable from sensor modules (2) that are not defined in accordance with the corresponding pairing information piece, and
- the one or more sensor modules (2) transmit a unique identification information piece on the basis of which the evaluation and communication unit (1) identifies the information piece and assigns it to a measurement task.

2. System according to claim 1, wherein the at least one power supply device (150, 250) is electrically connectable to the one or more sensor modules (2) for detecting information pieces, so that electrical energy is transmittable from the at least one power supply device (150, 250) to the one or more sensor modules (2) for detecting information pieces.

3. System according to claim 1 or 2, wherein the evaluation and communication unit (1) further comprises:
- at least one communication interface (140, 240), wherein the one or more information pieces that have been received are outputable by means of the at least one communication interface (140, 240).

4. System according to claim 3, wherein the one or more information pieces that have been received are outputable in encrypted form by means of the communication interface (140, 240).

5. System according to one of the preceding claims, wherein a data connection is establishable or exists from the evaluation and communication unit (1) to the one or more sensor modules (2) for detecting information pieces.

6. System according to one of the preceding claims, wherein the evaluation and communication unit (1) further comprises:
- at least one connection for a power line; and
- at least one connection for a data line;
- wherein the at least one connection for the power line and/or the at least one connection for the data line is connectable to corresponding connections of the one or more sensor modules (2) for detecting information pieces.

7. System according to one of the preceding claims, wherein the device for evaluating and/or storing information pieces (110, 210) is configured to further process one or more received information pieces.

8. System according to any of claims 1 to 7, wherein the one or more sensor modules (2) further comprise:
- at least one connection for a power line; and
- at least one connection for a data line;
- wherein the at least one connection for the power line and/or the at least one connection for the data line is connectable to corresponding connections of a further evaluation and communication unit (1).

9. System according to any of claims 1 to 8, wherein the one or more sensor modules (2) further comprise:
- means for converting (160) analog information into digital information, wherein information pieces detected by the one or more devices (170) for detecting information pieces is convertable by means of the means for converting (160) analog information into digital information.

10. System according to any one of claims 1 to 9, wherein the one or more sensor modules (2) further comprise:
- at least one communication interface, wherein the one or more information pieces that have been detected are outputable by means of the at least one communication interface.

11. System according to claim 10, wherein the one or more information pieces that have been detected are outputable in encrypted form by means of the at least one communication interface.

12. System according to any of claims 1 to 11, wherein the sensor module (2) comprises at least three devices for detecting information pieces (170-1 to 170-3) so that one or more electrical quantities of at least three phase alternating voltages are detectable.

## Revendications

1. Système comprenant
- une unité d'évaluation et de communication (1) ainsi qu'un ou plusieurs modules capteurs (2) pour enregistrer des informations ;
- où l'unité d'évaluation et de communication (1) comprend :
- au moins un dispositif d'alimentation électrique (150, 250) et
- un dispositif pour évaluer et/ou enregistrer des informations (110, 210) ;
- et où le ou les modules capteurs (2) comprennent :
- un ou plusieurs dispositifs pour capturer des informations (170, 270) ;
- où le ou les dispositifs pour capturer des informations (170, 270) sont alimentables en énergie électrique par le ou les dispositifs d'alimentation électrique (150, 250),
- où des informations (170) sont détectables au moyen du ou des dispositifs de capturer des informations, où les informations capturées sont indicatives d'une ou plusieurs grandeurs détectables électriquement, et où les informations capturées sont transmissibles par le ou les modules capteurs,
- où les informations sont recevables par l'unité d'évaluation et de communication (1),
- où l'unité d'évaluation et de communication (1) est séparée du ou des modules capteurs (2),
**caractérisé en ce**
- **que** le dispositif d'évaluer et/ou de enregistrer des informations (110, 210) est en outre configuré pour stocker une information d'appairage, où l'information d'appairage représente une association de l'unité d'évaluation et de communication (1) à un module de capteur défini (2) parmi le ou les modules de capteur (2), de sorte qu'aucune information est recevable provenant de modules capteurs (2) qui ne sont pas définis selon l'information d'appairage correspondante, et
- **que** le ou les modules capteurs (2) envoient des informations d'identification uniques à l'aide desquelles l'unité d'évaluation et de communication (1) identifie les informations et les attribue à une tâche de mesure.

2. Système selon la revendication 1, où le ou les dispositifs d'alimentation électrique (150, 250) est connectable électriquement au ou aux modules capteurs (2) pour détecter des informations, de sorte que de l'énergie électrique est transmissible du ou des dispositifs d'alimentation électrique (150, 250) au ou aux modules capteurs (2) pour détecter des informations.

3. Système selon la revendication 1 ou 2, où l'unité d'évaluation et de communication (1) comprend en outre :
- au moins une interface de communication (140, 240), où les un ou plusieurs informations reçues sont en outre émissibles via la au moins une interface de communication (140, 240).

4. Système selon la revendication 3, où la ou les informations reçues sont émissibles de manière cryptée via l'interface de communication (140, 240).

5. Système selon l'une des revendications précédentes, où une connexion de données établissable ou existe entre l'unité d'évaluation et de communication (1) et le ou les modules capteurs (2) pour enregistrer des informations.

6. Système selon l'une des revendications précédentes, où l'unité d'évaluation et de communication (1) comprend en outre :
- au moins un raccordement pour une ligne électrique ; et
- au moins un raccordement pour une ligne de données ;
où l'au moins un raccordement pour la ligne électrique et/ou l'au moins un raccordement pour la ligne de données sont connectables à des raccordements correspondants du ou des modules capteurs (2) pour la détection d'informations.

7. Système selon l'une des revendications précédentes, où le dispositif d'évaluer et/ou de stocker des informations (110, 210) est configuré pour traiter une ou plusieurs informations reçues.

8. Système selon l'une des revendications 1 à 7, où le ou les modules capteurs (2) comprennent en outre :
- au moins un raccordement pour une ligne électrique ; et
- au moins un raccordement pour une ligne de données ;
où l'au moins un raccordement pour la ligne électrique et/ou l'au moins un raccordement pour la ligne de données est connectable à des raccordements correspondants d'une autre unité d'évaluation et de communication (1).

9. Système selon l'une des revendications 1 à 8, où le ou les modules de capteurs (2) comprend en outre:
- des moyens pour convertir (160) une information analogique en une information numérique, où les moyens pour convertir (160) une information analogique en une information numérique permettent de convertir les informations détectées par le ou les dispositifs de détection d'informations (170).

10. Système selon l'une des revendications 1 à 9, où le ou les modules capteurs (2) comprennent en outre :
- au moins une interface de communication, où les informations détectées sont émissibles via l'au moins une interface de communication.

11. Système selon la revendication 10, où les informations détectées sont émissibles de manière cryptée via l'au moins une interface de communication.

12. Système selon l'une des revendications 1 à 11, où le module capteur (2) comprend au moins trois dispositifs de détection d'informations (170-1 à 170-3), de sorte qu'une ou plusieurs grandeurs électriques d'au moins trois tensions alternatives sont détectables.
